# EUROPEAN PATENT SPECIFICATION

(11) **EP 1 380 897 B1**
(45) Date of publication and mention of the grant of the patent: **12.03.2008**
(21) Application number: 03254304.3
(22) Date of filing: 07.07.2003
(51) Int. Cl.: G03F 7/20

(54) **Lithographic apparatus and device manufacturing method**
Lithographischer Apparat und Verfahren zur Herstellung einer Vorrichtung
Appareil lithographique et méthode de fabrication d'un dispositif

(30) Priority: 09.07.2002 EP 02254786
(43) Date of publication of application: 14.01.2004
(73) Proprietor: ASML Netherlands B.V., 5504 DR Veldhoven (NL)
(72) Inventor: Bleeker, Arno Jan, 5563 CE Westerhoven (NL); Banine, Vadim Yevgenyevich, 5704 NK Helmond (NL)
(74) Representative: Leeming, John Gerard

(56) References cited:
- US-A1- 2003 003 372
- US-B1- 6 188 519
- US-B1- 6 301 000
- CHOKSI N ET AL: "Maskless extreme ultraviolet lithography" JOURNAL OF VACUUM SCIENCE AND TECHNOLOGY: PART B, AMERICAN INSTITUTE OF PHYSICS. NEW YORK, US, vol. 17, no. 6, November 1999 (1999-11), pages 3047-3051, XP002183158 ISSN: 0734-211X
- PATENT ABSTRACTS OF JAPAN vol. 2000, no. 04, 31 August 2000 (2000-08-31) -& JP 2000 028931 A (TDK CORP), 28 January 2000 (2000-01-28)

## Description

The present invention relates to a lithographic projection apparatus comprising:
- a radiation system for supplying a projection beam of radiation;
- programmable patterning means for patterning the projection beam according to a desired pattern;
- a substrate table for holding a substrate; and
- a projection system for projecting the patterned beam onto a target portion of the substrate.

Lithographic projection apparatus are used in the manufacture of integrated circuits (ICs), flat panel displays and other devices involving fine structures. The programmable patterning means generates a pattern corresponding to an individual layer of, for example, the IC, and this pattern is imaged onto a target portion (*e.g.* comprising part of, one or several dies) on a substrate (*e.g*. silicon wafer or glass plate) that has been coated with a layer of radiation-sensitive material (resist).

Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. These transfer procedures result in a patterned layer of resist on the substrate. One or more pattern steps, such as deposition, etching, ion-implantation (doping), metallization, oxidation, chemo-mechanical polishing, etc., follow, each of which is intended to finish, create or modify a layer of the device. If several layers are required, then the whole procedure, or a variant thereof, is repeated for each new layer. Eventually, an array of devices will be present on the substrate (wafer). These devices are then separated from one another by a technique such as dicing or sawing, whence the individual devices can be mounted on a carrier, connected to pins, etc.. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4.

In order to meet the demand for forming ever-smaller components on the devices produced with lithographic projection apparatus, shorter wavelength radiation, such as EUV radiation, must be used. However, conventional programmable patterning means are not suitable for use with EUV radiation. For example, the surface tension in the multilayer stacks used to reflect EUV light is very high and would bend the elements in a conventional spatial light modulator.

N. Choksi et al. J. Vac. Sci. Technol. B 17(6), 3047-3051 discloses a system for performing maskless lithography using EUV radiation having an array of reflectors that can be moved relative to adjacent reflectors, causing constructive or destructive interference.

It is an object of the present invention to provide a lithographic projection apparatus with a programmable patterning means that is suitable for use with EUV radiation.

This and other objects are achieved according to the invention in a lithographic apparatus comprising:
- a radiation system for providing a projection beam of radiation;
- programmable patterning means for patterning the projection beam according to a desired pattern;
- a substrate table for holding a substrate; and
- a projection system for projecting the patterned beam onto a target portion of the substrate;
wherein the programmable patterning means comprises a plurality of reflective elements, wherein each reflective element comprises first and second distributed Bragg reflectors that are substantially aligned with each other in the direction of the incident projection beam of radiation such that a portion of the radiation from the projection beam passes through the first distributed Bragg reflector and is incident on the second distributed Bragg reflector which reflects at least a portion of the incident radiation and a means for adjusting their separation in the said direction;
wherein, in a first position, the separation of the first and second distributed Bragg reflectors produces destructive interference between the reflections from the first and second distributed Bragg reflectors and the reflectivity of the reflective element is relatively low; and, in a second position, the separation of the first and second distributed Bragg reflectors produces constructive interference between the reflections from the first and second distributed Bragg reflectors and the reflectivity of the reflective element is relatively high.

This arrangement provides a programmable patterning means in which each reflective element may be controlled to switch between relatively high and relatively low reflections at a particular wavelength of radiation, including EUV radiation. Therefore by setting different reflective elements to different states, the programmable patterning means may impart the desired pattern to the beam.

The actuator used for adjusting the separation of the first and second distributed Bragg reflectors in each reflective element may also set the separation to be one of a plurality of positions, setting the reflectivity of the reflective element to be at a plurality of levels between the first position, in which the reflective is substantially zero, and the second position, in which the reflectivity is a maximum. This facilitates better control of the pattern imparted to the projection beam.

For ease of manufacturing the programmable patterning means, two or more of the reflective elements may have a common first distributed Bragg reflector. The reflectivity of each of the reflective elements is then be set by moving the second distributed Bragg reflectors relative to the common first distributed Bragg reflector.

Preferably, the projection beam of radiation is EUV radiation, the distributed Bragg reflectors are designed to be individually reflective of EUV radiation at the wavelength used and the difference in the separation of the first and second distributed Bragg reflectors between the first and second positions is approximately one quarter of the wavelength of the EUV radiation used. This arrangement provides the greatest contrast between the reflective elements' maximum and minimum reflectivity.

The means of adjusting the separation of the first and second distributed Bragg reflectors may be a piezoelectric-actuator. The performance of such actuators is well understood and it is possible to control the movement of such piezoelectric-actuators to a very high level of accuracy. This is required since the range of movement of the piezoelectric-actuator will be of the order of a few nanometers and the required accuracy will be in the sub-nanometer range. For example, to provide 10 grey levels between the first and second positions, the difference between the separation at adjacent positions will be approximately 0.2 to 0.5 nm.

Each reflective element may have an individual piezoelectric element for moving one of its distributed Bragg reflectors. Alternatively, two or more of the reflective elements may have a common piezoelectric element. This is possible because the piezoelectric effect is local to the electrode at which the voltage is supplied to the piezoelectric element. The local effect may be use to separately adjust the position of the distributed Bragg reflectors in each reflective element. Using a common piezoelectric element may significantly simplify the production of the programmable patterning means.

As a further alternative, the means for adjusting the separation of the first and second distributed Bragg reflectors may be by means of an electrostatic actuator. This may reduce the complexity of the programmable patterning means and facilitate its manufacture since it does not require the provision of piezoelectric elements.

According to a further aspect of the invention there is provided:
a device manufacturing method comprising the steps of:
   - providing a substrate;
   - providing a projection beam of radiation using a radiation system;
   - using programmable patterning means to pattern the projection beam; and
   - projecting the patterned beam of radiation onto a target portion of the substrate;
wherein said programmable patterning means comprises a plurality of reflective elements;
wherein each reflective element comprises first and second distributed Bragg reflectors that are substantially aligned with each other in the direction of the incident projection beam of radiation such that a portion of the radiation from the projection beam passes through the first distributed Bragg reflector and is incident on the second distributed Bragg reflector which reflects at least a portion of the incident radiation and a means for adjusting their separation in the said direction;
wherein, in a first position, the separation of the first and second distributed Bragg reflectors produces destructive interference between the reflections from the first and second distributed Bragg reflectors and the reflectivity of the reflective element is relatively low; and, in a second position, the separation of the first and second distributed Bragg reflectors produces constructive interference between the reflections from the first and second distributed Bragg reflectors and the reflectivity of the reflective element is relatively high;
and in that the method further comprises the step of setting the distance between each said pair of distributed Bragg reflectors to provide the desired reflectivity of each reflective element in accordance with a desired pattern.

The term "programmable patterning means" as here employed should be broadly interpreted as referring to any means that can be used to endow an incoming radiation beam with a patterned cross-section, so that a desired pattern can be created in a target portion of the substrate; the terms "light valve" and "Spatial Light Modulator" (SLM) can also be used in this context. Examples of such patterning means include:
- A programmable mirror array. According to an example not forming part of the invention, this may comprise a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate spatial filter, the said undiffracted light can be filtered out of the reflected beam, leaving only the diffracted light to reach the substrate; in this manner, the beam becomes patterned according to the addressing pattern of the matrix-addressable surface. An array of grating light valves (GLV) can also be used in a corresponding manner. Each GLV is comprised of a plurality of reflective ribbons that can be deformed relative to one another to form a grating that reflects incident light as diffracted light. A further alternative example not forming part of the invention of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the programmable patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096.
- A programmable LCD array according to an example not forming part of the invention. An example of such a construction is given in United States Patent US 5,229,872.

It should be appreciated that where pre-biasing of features, optical proximity correction features, phase variation techniques and multiple exposure techniques are used, the pattern "displayed" on the programmable patterning means may differ substantially from the pattern eventually transferred to a layer of or on the substrate.

For the sake of simplicity, the projection system may be referred to as the "lens"; however, this term should be broadly interpreted as encompassing various types of projection system, including refractive optics, reflective optics, catadioptric systems and micro lens arrays, for example. It is to be understood that the term "projection system" as used in this application simply refers to any system for transferring the patterned beam from the programmable patterning means to the substrate. The radiation system may also include components operating according to any of these design types for directing, shaping or controlling the projection beam of radiation, and such components may also be referred to below, collectively or singularly, as a "lens". It has been proposed to fill a space between the final element of the projection system and the substrate with a liquid that has a refractive index of greater than one. This enables imaging of smaller features because the exposure radiation will have a shorter wavelength in liquid. The present invention may be used with apparatus of this type. Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, thin film transistor liquid crystal displays, printed circuit boards (PCBs), etc.

In the present document, the terms "radiation" and "beam" are used to encompass all types of electromagnetic radiation, including ultraviolet radiation (*e.g.* with a wavelength of 365, 248, 193, 157 or 126 nm) and EUV (extreme ultra-violet radiation, *e.g*. having a wavelength in the range 5-20 nm), as well as particle beams, such as ion beams or electron beams.

Exemplary embodiments of the invention will now be described, by way of example only, with reference to the accompanying schematic drawings, in which:
Figure 1 depicts a lithographic projection apparatus according to an embodiment of the invention;
Figure 2 depicts a distributed Bragg reflector suitable for use in the present invention;
Figure 3 depicts the use of two distributed Bragg reflectors to create an element with adjustable reflectivity;
Figure 4 depicts a portion of a programmable patterning means according to the present invention;
Figure 5 depicts a portion of a further programmable patterning means according to the present invention;
Figure 6 depicts a portion of a piezoelectric-actuator-driven programmable patterning means according to the present invention; and
Figure 7 depicts a portion of an electrostatic-actuator-driven programmable patterning according to the present invention.

In the Figures, corresponding reference symbols indicate corresponding parts.

### Embodiment 1

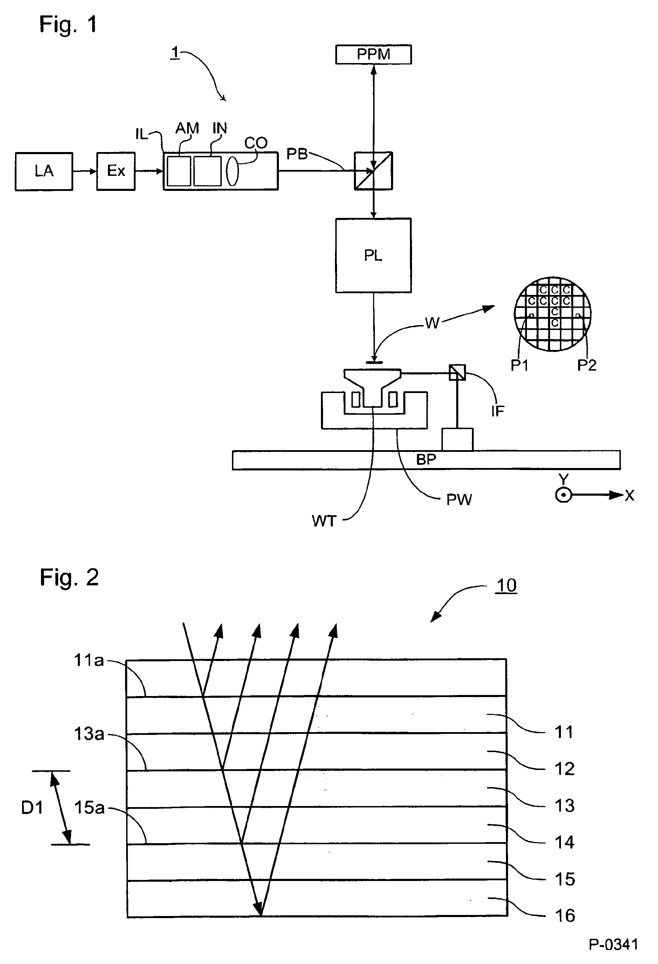

Figure 1 schematically depicts a lithographic projection apparatus according to a particular embodiment of the invention. The apparatus comprises:
- a radiation system Ex, IL, for supplying a projection beam PB of radiation (*e.g.* UV radiation), which in this particular case also comprises a radiation source LA;
- a programmable patterning means PPM (e.g. a programmable mirror array) for applying a pattern to the projection beam; in general the position of the programmable patterning means will be fixed relative to item PL; however it may instead be connected to a positioning means for accurately positioning it with respect to item PL;
- an object table (substrate table) WT provided with a substrate holder for holding a substrate W (*e.g.* a resist-coated silicon wafer), and connected to positioning means for accurately positioning the substrate with respect to item PL;
- a projection system ("lens") PL (*e.g.* a quartz and/or CaF₂ lens system or a catadioptric system comprising lens elements made from such materials, or a mirror system) for projecting the patterned beam onto a target portion C (*e.g.* comprising one or more dies) of the substrate W; the projection system may project an image of the programmable patterning means onto the substrate; alternatively, the projection system may project images of secondary sources for which the elements of the programmable patterning means act as shutters; the projection system may also comprise a micro lens array (known as an MLA), *e.g.* to form the secondary sources and to project microspots onto the substrate.

As here depicted, the apparatus is of a reflective type (*i.e.* has a reflective programmable patterning means).

The source LA (*e.g.* an excimer laser) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the programmable patterning means PPM has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and Claims encompass both of these scenarios.

The beam PB subsequently intercepts the programmable patterning means PPM. Having been reflected by the programmable patterning means PPM, the beam PB passes through the projection system PL, which focuses the beam PB onto a target portion C of the substrate W. With the aid of the positioning means (and interferometric measuring means IF), the substrate table WT can be moved accurately, *e.g*. so as to position different target portions C in the path of the beam PB. Where used, the positioning means for the programmable patterning means can be used to accurately correct the position of the programmable patterning means PPM with respect to the path of the beam PB, *e.g.* during a scan. In general, movement of the object table WT is realized with the aid of a long-stroke module (course positioning) and a short-stroke module (fine positioning), which are not explicitly depicted in Figure 1. A similar system may also be used to position the programmable patterning means. It will be appreciated that the projection beam may alternatively/additionally be moveable while the object table and/or the programmable patterning means may have a fixed position to provide the required relative movement.

Although the lithography apparatus according to the invention is herein described as being for exposing a resist on a substrate, it will be appreciated that the invention is not limited to this use and the apparatus may be used to project a patterned projection beam for use in resistless lithography.

The depicted apparatus can be used in four preferred modes:
1. Step mode: the entire pattern on the programmable patterning means is projected in one go (i.e. a single "flash") onto a target portion C. The substrate table WT is then moved in the x and/or y directions to a different position for a different target portion C to be irradiated by the beam PB.
2. Scan mode: essentially the same as step mode, except that a given target portion C is not exposed in a single "flash". Instead, the programmable patterning means is movable in a given direction (the so-called "scan direction", e.g. the y direction) with a speed v, so that the projection beam PB is caused to scan over the programmable patterning means; concurrently, the substrate table WT is simultaneously moved in the same or opposite direction at a speed V = Mv, in which M is the magnification of the lens PL. In this manner, a relatively large target portion C can be exposed, without having to compromise on resolution.
3. Pulse mode: the programmable patterning means is kept essentially stationary and the entire pattern is projected onto a target portion C of the substrate using a pulsed radiation source. The substrate table WT is moved with an essentially constant speed such that the projection beam PB is caused to scan a line across the substrate W. The pattern on the programmable patterning means is updated as required between pulses of the radiation system and the pulses are timed such that successive target portions C are exposed at the required locations on the substrate. Consequently, the projection beam can scan across the substrate W to expose the complete pattern for a strip of the substrate. The process is repeated until the complete substrate has been exposed line by line.
4. Continuous scan mode: essentially the same as pulse mode except that a substantially constant radiation source is used and the pattern on the programmable patterning means is updated as the projection beam scans across the substrate and exposes it.

Combinations and/or variations on the above described modes of use or entirely different modes of use may also be employed.

Figure 2 shows a distributed Bragg reflector of the kind used in the present invention. The distributed Bragg reflector is comprised of a multilayer stack 10. For a distributed Bragg reflector for EUV the stack 10 may, for example, be comprised of layers 11, 13, 15 of molybdenum, interposed with layers 12, 14, 16 of silicon. The high reflectivity (of approximately 70%) occurs due to the constructive interference of the radiation reflected from the upper surfaces 11a, 13a, 15a of the metal layers 11, 13, 15. In order to maximize the construction of this interference, the distance between the upper surfaces 11a, 13, 15a of the metal layers in the direction in which the radiation is directed (i.e. taking into account the angle of incidence) should be a multiple of half of the wavelength of the radiation used. Although the distributed Bragg reflector in Figure 2 is shown with three metal layers, it will be appreciated that in practice a much larger number of layers, for example 80 layers, may be used for optimum reflectivity. Further information on distributed Bragg reflectors may be found in EP 1,065,532A and EP 1,065,568A.

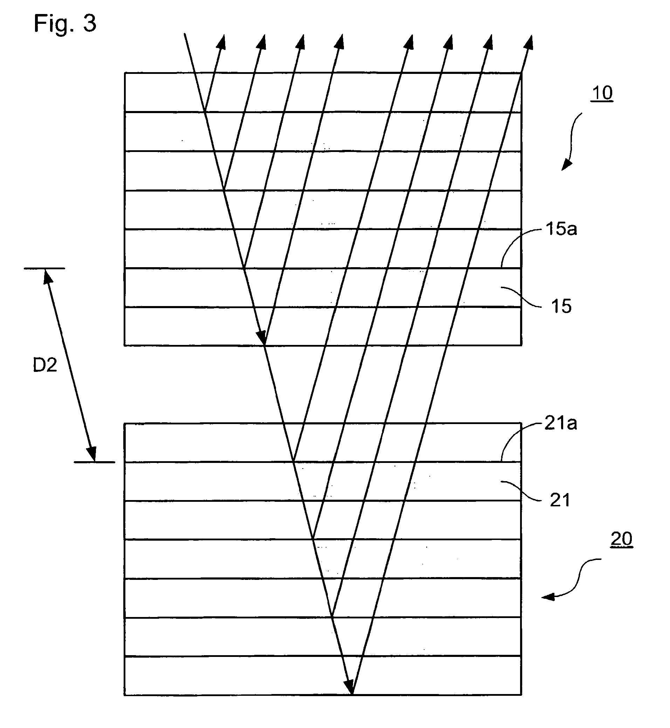

Figure 3 schematically represents a reflective element of a programmable patterning means used in the present invention. The programmable patterning means is comprised of a plurality of the reflective elements arranged on a surface onto which the projection beam of radiation is incident. Each of the reflective elements can be individually controlled, such that by changing the reflectivity of some of the reflective elements, the beam reflected by the programmable patterning means contains a desired pattern in its cross-section. Each of the reflective elements is comprised of two distributed Bragg reflectors 10, 20 that are aligned with each other in the direction of the incident projection beam of radiation such that any radiation that passes through the first distribution Bragg reflector 10 is incident on the second distributed Bragg reflector 20. When the distance D2 between the upper surfaces 15a, 21a of the metal layers of the two distributed Bragg reflectors 10, 20 in the direction of the beam of radiation (i.e. taking account of the angle of incidence of the beam) is a multiple of half the wavelength of the beam of radiation the reflections from the two distributed Bragg reflectors 10, 20 constructively interfere and the total reflection is at a maximum. When, however, the distributed Bragg reflectors 10, 20 are positioned such that the distance D2 is altered from the previous position by a quarter of the wavelength of the radiation, as shown in Figure 3, then negative interference between the reflection from the first distributed Bragg reflector 10 and the reflection from the second distributed Bragg reflector 20 will result in substantially zero reflectivity of the reflective element. By adjusting the value of the distance D2 to be in between these two positions, intermediate levels of reflectivity, between zero and the maximum, can be attained. Preferably the distance D2 can be adjusted to any one of approximately 200 positions between the positions for the maximum and minimum reflectivity. Alternatively, the position of the distributed Bragg reflectors may be controlled to allow a continuous range of settings of distance D2.

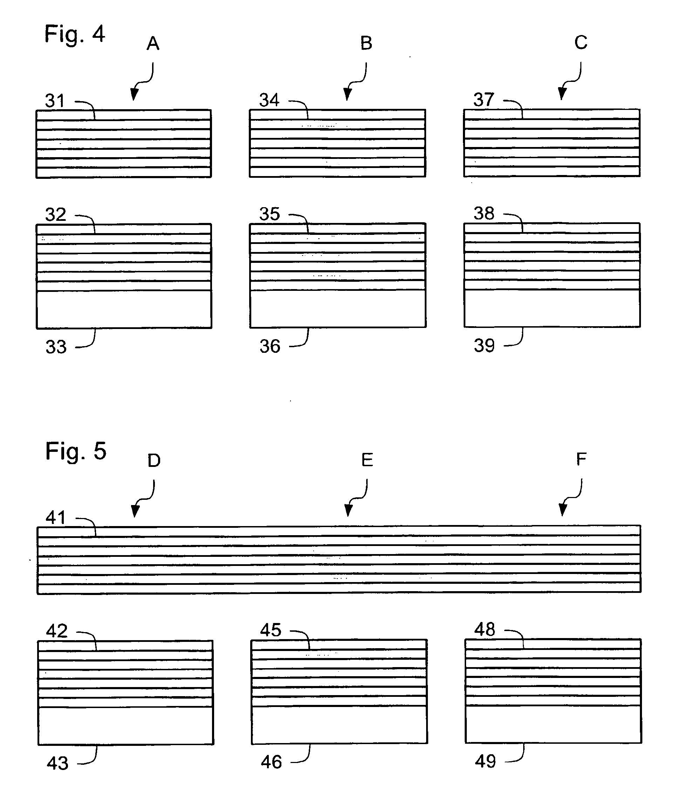

Figure 4 schematically shows three reflective elements A, B, C of a programmable patterning means according to the present invention. Reflective element A is comprised of two distributed Bragg reflectors 31, 32, as described before, and a piezoelectric-actuator 33. Similarly, reflective element B is comprised of distributed Bragg reflectors 34, 35 and piezoelectric element 36 and reflective element C is comprised of distributed Bragg reflectors 37, 38 and piezoelectric-actuator 39. By applying voltages to the piezoelectric-actuators 33, 36, 39 the position of the lower distributed Bragg reflectors 32, 35, 38 may be moved relative to the upper distributed Bragg reflectors 31, 34, 37, respectively, thereby altering the reflectivity of each of the reflective elements A, B, C.

As shown in Figure 4, each of the reflective elements A, B, C have a discrete piezoelectric element 33, 36, 39, respectively. However, two or more of the reflective elements may have a common piezoelectric element. The piezoelectric effect is limited to a region immediately surrounding the voltage applied to a piezoelectric element. Therefore, by only providing the voltage to a region of the common piezoelectric element corresponding to a particular reflective element, only the lower distributed Bragg reflector of that reflective element will be moved and therefore only the reflectivity of that reflective element will be adjusted. Thus, by attaching a plurality of electrodes to a single piezoelectric element, a plurality of reflective elements sharing the piezoelectric element can be controlled.

Figure 5 depicts a further variant of this embodiment. Each of the reflective elements D, E, F, has its own lower distributed Bragg reflector 42, 45, 48, the position of which may be adjusted with piezoelectric-actuators 43, 46, 49. However in this case the reflective elements D, E, F share a common upper distributed Bragg reflector 41. Depending on the size of the programmable mask, the upper distributed Bragg reflector 41 may be common to all the reflective elements in the programmable mask or just to a section of it. As before, the reflective elements may share a common piezoelectric element.

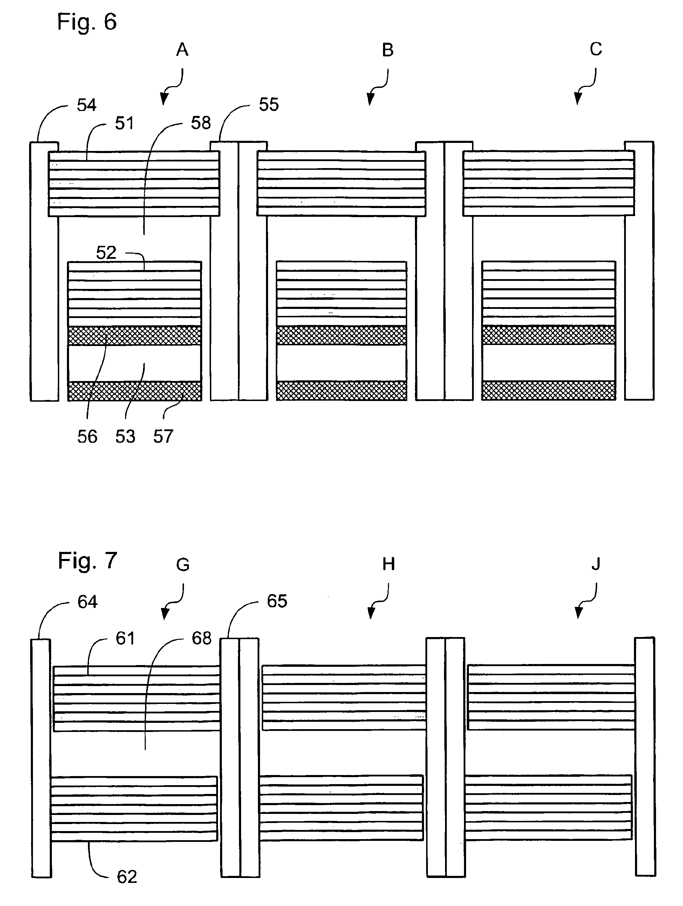

Figure 6 shows the embodiment of Figure 4 in more detail. The upper distributed Bragg reflector 51 of each reflective element A, B, C is supported by supports 54, 55. The supports may, as shown in Figure 6, be columns between the reflective elements A, B, C. Alternatively, a mesh-like structure may be formed onto which the upper distributed Bragg reflectors 51 are placed. The lower distributed Bragg reflectors 52 are supported on a piezoelectric layer 53. The gap 58 between the two distributed Bragg reflectors may be filled with a porous material, provided it is substantially transparent to the beam of radiation, or may be vacuum. The piezoelectric element 53 has upper and lower electrodes 56, 57 respectively, to provide the voltage to actuate the piezoelectric actuators and thereby alter the size of the gap 58 between the upper and lower distributed Bragg reflectors. The upper electrode layer 56 may be common for all the reflective elements, the actuation signal being provided by the lower electrode layer 57. Alternatively, the lower distributed Bragg reflector may be used as the top electrode. As discussed before, the upper distributed Bragg reflector and/or the piezoelectric element may be common for some or all of the reflective elements.

### Embodiment 2

Figure 7 depicts an alternative embodiment of the present invention in which, by using the top and bottom distributed Bragg reflectors 61, 62 as electrodes, the distance between the distributed Bragg reflectors can be adjusted using electrostatic attraction. In this case the support 64, 65 would need to be used to provide the signals to the distributed Bragg reflectors and the gap 68 between the distributed Bragg reflectors would need to be electrically non-conductive. The gap may be a vacuum or filled with a porous material.

As the electrostatic force between the two distributed Bragg reflectors 61, 62 increases, the supports 64, 65 bend, varying the separation between the distributed Bragg reflectors.

An advantage of this embodiment is that it requires less than the tens of volts needed to produce the required movement of the piezoelectric elements.

Whilst specific embodiments of the invention have been described above, it will be appreciated that the invention may be practiced otherwise than as described. The description is not intended to limit the invention which is defined by the claims.

## Claims

1. A lithographic projection apparatus comprising:
- a radiation system (LA, IL) for providing a projection beam of radiation (PB);
- programmable patterning means (PPM) for patterning the projection beam according to a desired pattern;
- a substrate table (WT) for holding a substrate (W); and
- a projection system (PL) for projecting the patterned beam onto a target portion (C) of the substrate;
wherein the programmable patterning means (PPM) comprises a plurality of reflective elements, each reflective element comprising first and second distributed Bragg reflectors (31, 32) and a means (33) for adjusting their separation in the direction of the incident projection beam of radiation; wherein, in a first position, the separation of the first and second distributed Bragg reflectors (31, 32) produces destructive interference between the reflections from the first and second distributed Bragg reflectors and the reflectivity of the reflective element is relatively low; and, in a second position, the separation of the first and second distributed Bragg reflectors (31, 32) produces constructive interference between the reflections from the first and second distributed Bragg reflectors and the reflectivity of the reflective element is relatively high, **characterised in that** said first and second distributed Bragg reflectors are substantially aligned with each other in the said direction such that a portion of the radiation from the projection beam passes through the first distributed Bragg reflector (31) and is incident on the second distributed Bragg reflector (32) which reflects at least a portion of the incident radiation.

2. A lithographic projection apparatus according to claim 1, wherein the means (53) for adjusting the position of the first and second distributed Bragg reflectors (31, 32) can be set to a plurality of positions between the first and second positions, providing a range of possible settings of the reflectivity of the reflective element.

3. A lithographic projection apparatus according to and one of the preceding claims, wherein two or more of the reflective elements (D, E, F) have a common first distributed Bragg reflector (41).

4. A lithographic projection apparatus according to any one of the preceding claims, wherein the projection beam of radiation (PB) is EUV radiation and the difference in the separation of the first and second distributed Bragg reflectors (31, 32) between the first and second positions is substantially one quarter of the wavelength of the EUV radiation.

5. A lithographic projection apparatus according to any one of the preceding claims, wherein the means (33) for adjusting the separation of the first and second distributed Bragg reflectors (31, 32) is a piezoelectric-actuator

6. A lithographic projection apparatus according to claim 5, wherein two or more of the reflective elements have a common piezoelectric element but each reflective element has at least one electrode associated only with that reflective element for producing a piezoelectric effect local to that reflective element.

7. A lithographic projection apparatus according to any one of the claims 1 to 4, wherein the means for adjusting the separation of the first and second distributed Bragg reflectors (61, 62) is an electrostatic actuator.

8. A device manufacturing method comprising the steps of:
- providing a substrate (W);
- providing a projection beam of radiation (PB) using a radiation system (LA, IL);
- using programmable patterning means (PPM) to pattern the projection beam; and
- projecting the patterned beam of radiation onto a target portion of the substrate;
wherein said programmable patterning means comprises a plurality of reflective elements; wherein each reflective element comprises first and second distributed Bragg reflectors (31, 32) that are substantially aligned with each other in the direction of the incident projection beam of radiation such that a portion of the radiation from the projection beam passes through the first distributed Bragg reflector (31) and is incident on the second distributed Bragg reflector (32) which reflects at least a portion of the incident radiation and a means (33) for adjusting their separation in the said direction;
wherein, in a first position, the separation of the first and second distributed Bragg reflectors (31, 32) produces destructive interference between the reflections from the first and second distributed Bragg reflectors and the reflectivity of the reflective element is relatively low; and, in a second position, the separation of the first and second distributed Bragg reflectors (31, 32) produces constructive interference between the reflections from the first and second distributed Bragg reflectors and the reflectivity of the reflective element is relatively high; and in that the method further comprises the step of setting the distance between each said pair of distributed Bragg reflectors (31, 32) to provide the desired reflectivity of each reflective element in accordance with a desired pattern.

## Patentansprüche

1. Ein lithographischer Projektionsapparat, aufweisend:
- ein Strahlungssystem (LA, IL) zur Bereitstellung eines Projektionsstrahls einer Strahlung (PB);
- programmierbare Musterungsmittel (PPM) zur Musterung des Projektionsstrahls gemäß einem gewünschten Muster;
- einen Substrattisch (WT) zum Halten eines Substrats (W); und
- ein Projektionssystem (PL) zum Projizieren des gemusterten Strahls auf einen Zielabschnitt (C) eines Substrats (W);
wobei die programmierbaren Musterungsmittel (PPM) eine Mehrzahl reflektierender Elemente aufweisen, wobei jedes reflektierende Element erste und zweite verteilte Bragg-Reflektoren (31, 32) aufweist, sowie Mittel (33) zur Einstellung von deren Trennung voneinander in Richtung des einfallenden Projektionsstrahls der Strahlung, wobei in einer ersten Position die Trennung der ersten und zweiten verteilten Bragg-Reflektoren voneinander eine destruktive Interferenz zwischen den Reflektionen von den ersten und zweiten verteilten Bragg-Reflektoren erzeugt und das Reflektionsvermögen des reflektierenden Elements relativ niedrig ist und in einer zweiten Position die Trennung der ersten und zweiten verteilten Bragg-Reflektoren voneinander eine konstruktive Interferenz zwischen den Reflektionen von den ersten und zweiten verteilten Bragg-Reflektoren erzeugt und das Reflektionsvermögen des reflektierenden Elements relativ hoch ist,
**dadurch gekennzeichnet, dass** die ersten und zweiten verteilten Bragg-Reflektoren in besagter Richtung im wesentlichen in Fluchtung miteinander derart sind, dass ein Teil der Strahlung des Projektionsstrahls durch den ersten verteilten Bragg-Reflektor (31) läuft und auf den zweiten verteilten Bragg-Reflektor (32) fällt, der wenigstens einen Teil der einfallenden Strahlung reflektiert.

2. Ein lithographischer Projektionsapparat nach Anspruch 1, bei dem die Mittel (33) zur Einstellung der Position des ersten und zweiten verteilten Bragg-Reflektors (31, 32) auf eine Mehrzahl von Positionen zwischen der ersten und d er zweiten Position setzbar sind, was einen Bereich von möglichen Einstellungen des Reflektionsvermögens des reflektierenden Elements schafft.

3. Ein lithographischer Projektionsapparat nach einem der vorhergehenden Ansprüche, bei dem zwei oder mehr der reflektierenden Elemente (D, E, F) einen gemeinsamen ersten verteilten Bragg-Reflektor (41) haben.

4. Ein lithographischer Projektionsapparat nach einem der vorhergehenden Ansprüche, bei dem der Projektionsstrahl der Strahlung (PB) EUV-Strahlung ist und die Differenz in der Trennung der ersten und zweiten verteilten Bragg-Reflektoren (31, 32) voneinander zwischen den ersten und zweiten Positionen im wesentlichen ein Viertel der Wellenlänge der EUV-Strahlung beträgt.

5. Ein lithographischer Projektionsapparat nach einem der vorhergehenden Ansprüche; bei dem die Mittel (33) zur Einstellung der Trennung der ersten und zweiten verteilten Bragg-Reflektoren (31, 32) voneinander ein piezoelektrisches Stellglied sind.

6. Ein lithographischer Projektionsapparat nach Anspruch 5, bei dem zwei oder mehr der reflektierenden Elemente ein gemeinsames piezoelektrisches Element haben, aber jedes reflektierende Element wenigstens eine Elektrode hat, die alleine diesem reflektierenden Element zugeordnet ist, um einen piezoelektrischen Effekt zu erzeugen, der auf dieses reflektierende Element begrenzt ist.

7. Ein lithographischer Projektionsapparat nach einem der Ansprüche 1 bis 4, bei dem die Mittel zur Einstellung der Trennung der ersten und zweiten verteilten Bragg-Reflektoren (61, 62) voneinander ein elektrostatisches Stellglied sind.

8. Ein Verfahren zur Herstellung einer Vorrichtung, aufweisend die Schritte von:
- Bereitstellen eines Substrats (W);
- Bereitstellen eines Projektionsstrahls einer Strahlung (PB) unter Verwendung eines Strahlungssystems (LA, IL);
- Verwenden programmierbarer Musterungsmittel (PPM), um den Projektionsstrahl mit einem Muster zu versehen; und
- Projizieren des gemusterten Strahls der Strahlung auf einen Zielabschnitt des Substrats;
wobei die programmierbaren Musterungsmittel eine Mehrzahl reflektierender Elemente aufweisen;
wobei jedes reflektierende Element erste und zweite verteilte Bragg-Reflektoren (31, 32), welche in Richtung des einfallenden Projektionsstrahls der Strahlung im wesentlichen in Fluchtung miteinander derart sind, dass ein Teil der Strahlung des Projektionsstrahls durch den ersten verteilten Bragg-Reflektor (31) läuft und auf den zweiten verteilten Bragg-Reflektor (32) fällt, der wenigstens einen Teil der einfallenden Strahlung reflektiert, sowie Mittel (33) zur Einstellung deren Trennung voneinander in besagter Richtung aufweist;
wobei in einer ersten Position die Trennung der ersten und zweiten verteilten Bragg-Reflektoren (31, 32) voneinander eine destruktive Interferenz zwischen den Reflektionen von den ersten und zweiten verteilten Bragg-Reflektoren erzeugt und das Reflektionsvermögen des reflektierenden Elements relativ niedrig ist und in einer zweiten Position die Trennung der ersten und zweiten verteilten Bragg-Reflektoren (31, 32) voneinander eine konstruktive Interferenz zwischen den Reflektionen von den ersten und zweiten verteilten Bragg-Reflektoren erzeugt und das Reflektionsvermögen des reflektierenden Elements relativ hoch ist,
wobei das Verfahren weiterhin den Schritt des Festsetzens des Abstands zwischen jedem Paar von verteilten Bragg-Reflektoren (31, 32) aufweist, um das gewünschte Reflektionsvermögen eines jeden reflektierenden Elements gemäß einem gewünschten Muster zu liefern.

## Revendications

1. Appareil de projection lithographique comprenant :
- un système de rayonnement (LA, IL) pour fournir un faisceau de projection de rayonnement (PB) ;
- des moyens programmables de mise en forme (PPM) pour mettre en forme le faisceau de projection conformément à un motif voulu ;
- une table de substrat (WT) pour supporter un substrat (W) ; et
- un système de projection (PL) pour projeter le faisceau mis en forme sur une partie cible (C) du substrat ;
dans lequel les moyens programmables de mise en forme (PPM) comprennent une pluralité d'éléments réflecteurs, chaque élément réflecteur comprenant des premier et second réflecteurs de Bragg répartis (31, 32) et des moyens (3) pour ajuster leur séparation dans la direction du faisceau de projection de rayonnement incident ; dans lequel, dans une première position, la séparation des premier et second réflecteurs de Bragg répartis (31, 32) produit une interférence destructrice entre les réflexions provenant des premier et second réflecteurs de Bragg répartis et la réflectivité de l'élément réflecteur est relativement faible ; et, dans une seconde position, la séparation des premier et second réflecteurs de Bragg répartis (31, 32) produit une interférence constructrice entre les réflexions provenant des premier et second réflecteurs de Bragg répartis et la réflectivité de l'élément réflecteur est relativement élevée, **caractérisé en ce que** lesdits premier et second réflecteurs de Bragg répartis sont sensiblement alignés l'un avec l'autre dans ladite direction de sorte qu'une partie du rayonnement provenant du faisceau de projection passe à travers le premier réflecteur de Bragg réparti (31) et est incidente sur le second réflecteur de Bragg réparti (32) qui réfléchit au moins une partie du rayonnement incident.

2. Appareil de projection lithographique selon la revendication 1, dans lequel les moyens (53) pour ajuster la position des premier et second réflecteurs de Bragg répartis (31, 32) peuvent être fixés dans une pluralité de positions entre la première et la seconde position, fournissant une plage de réglages possibles de la réflectivité de l'élément réflecteur.

3. Appareil de projection lithographique selon l'une quelconque des revendications précédentes, dans lequel deux ou plus des éléments réflecteurs (D, E, F) ont un premier réflecteur de Bragg réparti commun (41).

4. Appareil de projection lithographique selon l'une quelconque des revendications précédentes, dans lequel le faisceau de projection de rayonnement (PB) est un rayonnement EUV (UV extrême) et la différence dans la séparation des premier et second réflecteurs de Bragg répartis (31, 32) entre les première et seconde positions est sensiblement un quart de la longueur d'onde du rayonnement EUV.

5. Appareil de projection lithographique selon l'une quelconque des revendications précédentes, dans lequel les moyens (33) pour ajuster la séparation des premier et second réflecteurs de Bragg répartis (31, 32) sont un actionneur piézoélectrique.

6. Appareil de projection lithographique selon la revendication 5, dans lequel deux ou plus de deux des éléments réflecteurs ont un élément piézoélectrique commun mais chaque élément réflecteur a au moins une électrode associée uniquement à cet élément réflecteur pour produire un effet piézoélectrique local sur cet élément réflecteur.

7. Appareil de projection lithographique selon l'une quelconque des revendications 1 à 4, dans lequel les moyens pour ajuster la séparation des premier et second réflecteurs de Bragg répartis (61, 62) sont un actionneur électrostatique.

8. Procédé de fabrication d'un dispositif, comprenant les étapes suivantes :
- fournir un substrat (W) ;
- fournir un faisceau de projection de rayonnement (PB) en utilisant un système de rayonnement (LA, IL) ;
- utiliser des moyens programmables de mise en forme (PPM) pour mettre en forme le faisceau de projection ; et
- projeter le faisceau de rayonnement mis en forme sur une partie cible du substrat ;
dans lequel lesdits moyens programmables de mise en forme comprennent une pluralité d'éléments réflecteurs ; chaque élément réflecteur comprenant des premier et second réflecteurs de Bragg répartis (31, 32) qui sont sensiblement alignés l'un avec l'autre dans la direction du faisceau de projection de rayonnement incident de telle sorte qu'une partie du rayonnement provenant du faisceau de projection passe à travers le premier réflecteur de Bragg réparti (31) et est incidente sur le second réflecteur de Bragg réparti (32) qui réfléchit au moins une partie du rayonnement incident, et des moyens (33) pour ajuster leur séparation dans ladite direction ;
dans lequel, dans une première position, la séparation des premier et second réflecteurs de Bragg répartis (31, 32) produit une interférence destructrice entre les réflexions provenant des premier et second réflecteurs de Bragg répartis et la réflectivité de l'élément réflecteur est relativement faible ; et dans une seconde position, la séparation des premier et second réflecteurs de Bragg répartis (31, 32) produit une interférence constructrice entre la réflexion provenant des premier et second réflecteurs de Bragg répartis et la réflectivité de l'élément réflecteur est relativement élevée ; et le procédé comprend de plus l'étape de fixation de la distance entre chaque dite paire de réflecteurs de Bragg répartis (31, 32) pour fournir la réflectivité voulue de chaque élément réflecteur conformément à un motif voulu.
